# EUROPÄISCHE PATENTSCHRIFT

(11) **EP 3 061 327 B1**
(45) Veröffentlichungstag und Bekanntmachung des Hinweises auf die Patenterteilung: **27.06.2018**
(21) Anmeldenummer: 14786213.0
(22) Anmeldetag: 20.10.2014
(51) Int. Cl.: H05K 7/14, H01R 9/24

(54) **ELEKTRONIKGERÄT**
ELECTRONIC DEVICE
APPAREIL ÉLECTRONIQUE

(30) Priorität: 21.10.2013 DE 102013111580
(43) Veröffentlichungstag der Anmeldung: 31.08.2016
(73) Patentinhaber: Wago Verwaltungsgesellschaft mbH, 32423 Minden (DE)
(72) Erfinder: MICKMANN, Viktor, 33604 Bielefeld (DE); BUCHMEIER, Axel, 31707 Heeßen (DE)
(74) Vertreter: Gerstein, Hans Joachim
(86) Internationale Anmeldenummer: PCT/EP2014/072441
(87) Internationale Veröffentlichungsnummer: WO 2015/059093

(56) Entgegenhaltungen:
- WO-A1-2011/120881
- DE-U1-202010 004 408

## Beschreibung

Die Erfindung betrifft ein Elektronikgerät mit einem Basismodul und einem auf das Basismodul lösbar aufsteckbaren Elektronikmodul, wobei das Basismodul ein Isolierstoffgehäuse mit einem Rastfuß zum Aufrasten des Basismoduls auf eine Tragschiene und Steckkontakte an den Seitenwänden aufweist, und wobei das Elektronikmodul ein Isolierstoffgehäuse aufweist und im aufgesteckten Zustand auf das Basismodul mit zugeordneten Steckkontakten des Basismoduls verbindbar ist, und wobei das Basismodul und das Elektronikmodul zusammenwirkende Rastelemente zur Verrastung von Basismodul und Elektronikmodul miteinander haben, wenn das Elektronikmodul auf das Basismodul aufgesteckt ist.

Derartige Elektronikgeräte werden insbesondere für dezentrale modulare Steuerungsanlagen eingesetzt. Eine Anzahl von solchen Elektronikgeräten wird dabei nebeneinander auf eine Tragschiene aufgesetzt. Ein Kopfmodul am Anfang einer solchen Reihe von Elektronikgeräten ist dabei als Feldbuskoppler oder Feldbuscontroller ausgeführt. In einem Feldbuscontroller kann dann ein Steuerungsprogramm ablaufen, das Feldbusteilnehmer, die an die einzelnen Elektronikgeräte anschließbar sind, ansteuern beziehungsweise Daten von Feldbusteilnehmern erfassen und mit dem Steuerungsprogramm auswerten und zur weiteren Steuerung der Feldbusgeräte nutzen. Solche Feldbusgeräte können Aktoren, Sensoren oder sonstige Geräte sein.

Mit Hilfe der Steckkontakte an den Seitenwänden wird ein Datenbus etabliert, mit dem Daten zwischen dem Kopfmodul und den Elektronikgeräten und gegebenenfalls zwischen den Elektronikgeräten selbst ausgetauscht werden können. Diese Daten können Steuerungs-, Messdaten oder sonstige Daten sein. Mit Hilfe der Steckkontakte an den Seitenwänden der Elektronikgeräte wird weiterhin eine durchgehende Spannungsversorgung für die Elektronikgeräte bereitgestellt, um die elektronischen Bauelemente des Elektronikgerätes mit elektrischer Leistung zu versorgen. Weiterhin können Steckkontakte an den Seitenwänden vorzugsweise beabstandet zu den Steckkontakten für den Datenbus und die Systemspannungsversorgung vorhanden sein, um eine Leistungsversorgung bereitzustellen, mit denen die an die Elektronikgeräte anschließbaren Feldbusteilnehmer mit elektrischer Leistung versorgt werden. Diese Steckkontakte sind zumeist für einen wesentlich höheren Stromfluss ausgelegt, als die Steckkontakte für die Systemspannungsversorgung und für den Datenbus.

Zum Beispiel aus der DE 10 2011 110 182 A1 ist eine modulare Steuerungsvorrichtung bekannt, bei der die Elektronikgeräte dreiteilig mit einem Basismodul, einem darauf aufsetzbaren Elektronikmodul und einem auf das Elektronikmodul aufsetzbaren Leiteranschlussmodul ausgeführt ist. Das Leiteranschlussmodul hat dabei Leiteranschlusskontakte zum Anschließen von elektrischen Leitern. In dem auf das Elektronikmodul aufgesteckten Zustand des Leiteranschlussmoduls werden die einzelnen Leiteranschlusskontakte elektrisch leitend mit dem Elektronikmodul verbunden. Durch das Aufstecken des Elektronikmoduls auf das Basismodul wird das Elektronikmodul elektrisch leitend mit den Steckkontakten an den Seitenwänden des Basismoduls verbunden. Das Basismodul hat einen Rastfuß zum Aufsetzen des Basismoduls auf eine Tragschiene. Das Leiteranschlussmodul ist vom Elektronikmodul abnehmbar, so dass zum Austauschen des Elektronikmoduls zum Beispiel bei defekter Elektronik die elektrischen Leitungen nicht einzeln von dem Elektronikgerät abgeklemmt werden müssen. Das Leiteranschlussmodul ist dabei an einer Stirnseitenwand drehgelenkig mit dem Elektronikmodul verbunden. Das Elektronikmodul ist seinerseits auf der gegenüberliegenden Seite drehgelenkig mit dem Basismodul verbindbar. Das Leiteranschlussmodul ist schwenkbar in einem Lager aufgenommen, das an einem federelastischen Rastarm des Elektronikmoduls vorhanden ist. Der Rastarm hat eine in eine Rastöffnung des Basismoduls eintauchende Rastnase. Damit kann das Elektronikmodul zusammen mit dem Leiteranschlussmodul durch Betätigung des Rastarms vom Basismodul heruntergeschwenkt werden.

Bei diesem bekannten Elektronikgerät ist es sehr einfach auch im Betrieb möglich, das Elektronikmodul zusammen mit dem Leiteranschlussmodul vom Basismodul abzuziehen. Dies kann zu erheblichen Problemen in der gesteuerten Anlage führen, wenn das Abziehen zum Beispiel ungewollt im laufenden Betrieb erfolgt. Ein weiteres Beispiel eines Elektronikgeräts mit einem auf ein Basismodul aufsteckbaren Elektronikmodul wird in der DE-U-202010004408 offenbart. Ausgehend hiervon ist es Aufgabe der vorliegenden Erfindung ein verbessertes Elektronikgerät zu schaffen, bei dem ein Austausch des Elektronikmoduls werkzeuglos auf möglichst einfache Weise und dennoch abgesichert erfolgt. Die Aufgabe wird durch das Elektronikgerät mit den Merkmalen des Anspruchs 1 gelöst. Vorteilhafte Ausführungsformen sind in den Unteransprüchen beschrieben.

Für ein gattungsgemäßes Elektronikgerät wird vorgeschlagen, dass ein Rastelement des Elektronikmoduls an einer zweiten Stirnseite des Elektronikgerätes eine Betätigungsnase und an seiner der zweiten Stirnseite gegenüberliegenden ersten Stirnseite des Elektronikgerätes eine Griffnase hat, und dass das Elektronikmodul und das Basismodul miteinander zusammenwirkende Linearführungen haben, wobei das Elektronikmodul mit den Linearführungen an dem Basismodul linear verschiebbar gehalten und an dem Basismodul aufnehmbar ist.

Durch das an den einander gegenüberliegenden Stirnseiten angeordnete Paar von Betätigungsnase und Griffnase gelingt es in Verbindung mit der Linearführung an dem Elektronikmodul und dem Basismodul, dass das Elektronikmodul an der Betätigungsnase und der Griffnase mit einer Hand gegriffen und annähernd lotrecht von dem Basismodul nach oben weggezogen werden kann. Bei dem Übergreifen des Elektronikmoduls mit der Hand derart, dass die Finger einer Hand einerseits auf der Betätigungsnase und andererseits auf der Griffnase aufliegen, wird gleichzeitig das mit der Betätigungsnase zusammenwirkende Rastelement betätigt und das Elektronikmodul von dem Basismodul entrastet. Auf diese Weise gelingt das Abziehen des ansonsten mit dem mindestens einem Rastelement am Basismodul gesicherten Elektronikmoduls von dem Basismodul auf einfache Weise, wobei das Elektronikmodul im Betriebszustand trotzdem sicher an dem Basismodul angerastet ist. Das Herausziehen des Elektronikmoduls von dem Basismodul ist aber nur möglich, wenn das Elektronikmodul beidseits gegriffen wird. Anstelle eines Abschwenkens, das eine Krafteinwirkung nur auf einer Seite bedarf, ist das Elektronikmodul an dem Basismodul durch die Linearführung und die damit verbundene Notwendigkeit der gleichzeitigen Krafteinwirkung auf beiden aneinanderliegenden Stirnseitenenden gleichzeitig gesichert.

Unter einer "Nase" wird dabei ein gegenüber dem unmittelbar angrenzenden Bereich vorstehender Abschnitt verstanden. Dabei ist es nicht wesentlich, dass die Nase aus der durch die Stirnseite aufgespannten Ebene herausragt, das heißt aus der Stirnseitenwand hervorsteht, oder bereits vor oder auf der Ebene der Stirnseitenwand endet.

Besonders vorteilhaft ist es, wenn das die Betätigungsnase aufweisende Rastelement als elastisch federnder Rastarm ausgeführt ist, der an einer Stirnseitenwand des Elektronikmoduls angeordnet ist und an seinem freien Ende eine Rastnase hat. Diese Rastnase des elastisch federnden Rastarms ist dann so ausgebildet, dass die Rastnase im Aufsteckzustand des Elektronikmoduls auf dem Basismodul in eine an der Stirnseitenwand des Basismoduls ausgebildeten Rastöffnung zur Verriegelung des Elektronikmoduls am Basismodul eintaucht. Bei einem Drücken der vorstehenden Betätigungsnase in Richtung Elektronikmodul wird die Rastnase aus der Rastöffnung herausgeführt und das Elektronikmodul vom Basismodul entrastet. Es kann dann lotrecht zur durch die Unterseite des Basismoduls und durch die eine Tragschiene, auf die das Basismodul aufgesetzt ist, aufgespannte Ebene nach oben weg abgezogen werden.

Besonders vorteilhaft ist es dabei, wenn ein elastisch federnder Rastarm integral mit dem Isolierstoffgehäuse des Elektronikmoduls geformt ist. Der Rastarm hat die Betätigungsnase sowie an seinem freien Ende eine Rastnase und ist mit seinem freien Ende in dem am Basismodul verrasteten Aufsteckzustand zu dem Basismodul hin gerichtet. Dies hat den Vorteil, dass der federnde Rastarm beim Aufstecken des Elektronikmoduls auf das Basismodul durch eine geneigte Außenseite der Rastnase zunächst einmal in eine Offenstellung ausgelenkt wird und dann bei Erreichen der Rastöffnung im Aufsteckzustand durch die Federelastizität des Rastarms selbsttätig zurückfedert, so dass die Rastnase in die Rastöffnung eintaucht und ein die Rastöffnung am freien Ende des Rastarms begrenzender Quersteg einen Anschlag für die Rastnase bildet.

Hierzu ist an dem Isolierstoffgehäuse des Basismoduls eine in Richtung Elektronikmodul hervorstehende Rastlasche mit der durch einen Quersteg am freien Ende der Rastlasche begrenzten Rastöffnung vorgesehen.

Besonders vorteilhaft ist es wenn an einer Stirnseite des Elektronikgerätes Rastelemente mit dem elastisch federnden Rastarm und der zugeordneten Rastöffnung und an der gegenüberliegenden Stirnseite keine direkte Verrastung des Elektronikmoduls an dem Basismodul vorgesehen ist. Das Elektronikmodul ist somit nur an einer Seite mit einem elastisch federnden Rastarm mit dem Basismodul verrastet. Die gegenüberliegende Seite hat hingegen keine Rastmittel zwischen dem Elektronikmodul und dem Basismodul.

In diesem Zusammenhang ist es besonders vorteilhaft, wenn das Elektronikgerät ein auf das Elektronikmodul aufsteckbares Leiteranschlussmodul mit Leiteranschlussklemmen zum Anschließen von elektrischen Leitungen hat. Diese Leiteranschlussklemmen sind dann in dem Betriebszustand, in dem das Leiteranschlussmodul auf das Elektronikmodul aufgesteckt ist, elektrisch leitend mit dem Elektronikmodul verbunden. Damit können Feldbusteilnehmer über elektrische Leitungen an das Elektronikgerät angeschlossen werden. Das Leiteranschlussmodul und das Basismodul haben bei dieser bevorzugten Ausführungsform an der ersten Stirnseite, die dem elastisch federnden Rastarm und der zugeordneten Rastöffnung gegenüberliegt, Elemente zum Festlegen des Leiteranschlussmoduls an dem Basismodul. Damit wird auf der einen Seite das Elektronikmodul mit dem elastisch federnden Rastarm an dem Basismodul verrastet und an der gegenüberliegenden Seite das Leiteranschlussmodul mit dem Basismodul festgelegt. Dadurch, dass das Leiteranschlussmodul das Elektronikmodul überragt und direkt an dem Elektronikmodul eine Verriegelung aufweist, ist auf diese Weise das Elektronikmodul indirekt über die Verriegelung des Leiteranschlussmoduls an dem Basismodul festgelegt und vor Herausziehen gesichert. Dies hat den Vorteil, dass ein unbeabsichtigtes Demontieren des Elektronikgerätes zum Beispiel durch überhöhten Zug auf elektrische Leiter nicht möglich ist. Das Elektronikmodul kann nur dann vom Basismodul entfernt werden, wenn vorher das Leiteranschlussmodul durch Aufhebung der Fixierung zwischen Leiteranschlussmodul und Basismodul von dem darunterliegenden Elektronikmodul entfernt wurde. In einem separaten zweiten Schritt kann dadurch Druck auf die vorstehende Betätigungsnase und gegenüberliegende Griffnase das Elektronikmodul von dem Basismodul abgezogen werden.

In einer weiter bevorzugten Ausführungsform ragt die vorstehende Griffnase des Elektronikmoduls in eine Öffnung im Isolierstoffgehäuse des Basismoduls hinein. Besonders vorteilhaft ist es, wenn die vorstehende Griffnase dabei auch durch die Öffnung im Isolierstoffgehäuse des Basismoduls hindurchragt und aus der Stirnseitenwand des Basismoduls herausragt, um sicher und einfach von einem Finger über die Außenseite der zugehörigen Stirnseitenwand zum Herausziehen des Elektronikmoduls ergriffen zu werden.

Die Griffnase ist vorzugsweise benachbart zu einem im Betriebszustand auf das Elektronikmodul aufgesteckten Leiteranschlussmodul angeordnet, das heißt in einem von dem Sockel des Basismoduls mit dem Rastfuß entfernten Ort.

Der federnde Rastarm der Betätigungsnase ist bevorzugt näher an der durch die Unterseite des Basismoduls mit dem Rastfuß aufgespannten Ebene angeordnet, als die Griffnase, die der Betätigungsnase gegenüberliegt. Dies hat den Vorteil, dass das Elektronikmodul mit dem federnden Rastarm an dem Basismodul näher zur Tragschiene hin verriegelt ist und auf der gegenüberliegenden Seite die Griffnase so liegt, dass diese mit einer Hand noch erreicht werden kann, wenn auf der gegenüberliegenden Seite mit einem anderen Finger derselben Hand die Betätigungsnase des federnden Rastarms heruntergedrückt und zum Herausziehen gehalten wird.

Weiterhin ist es vorteilhaft, wenn die Betätigungsnase am elastisch federnden Rastarm und/oder die Griffnase eine Riffelung hat. Diese Riffelung kann beispielsweise durch quer zur Einsteckrichtung verlaufende und voneinander beabstandete Querstege gebildet werden.

Weiterhin ist es vorteilhaft, wenn die Linearführungen mindestens an einer Stirnseite schräg zulaufen, um das Elektronikmodul in eine Endlage zu führen. Eine gegenüberliegende Linearführung, die nicht notwendigerweise an einer Stirnseitenwand angeordnet sein muss, kann entweder lotrecht zur Ebene des Basismoduls und einer Tragschiene, auf die das Basismodul aufgesetzt wird, erstreckend ausgerichtet sein oder zumindest in einem Einführbereich leicht schräg zulaufend sein.

Die Erfindung wird nachfolgend anhand eines Ausführungsbeispiels mit den beigefügten Zeichnungen näher erläutert. Es zeigen:
- Figur 1 -: perspektivische Ansicht eines dreiteiligen Elektronikgeräts;
- Figur 2 -: Explosionsansicht des dreiteiligen Elektronikgeräts aus Figur 1 mit doppelt dargestellter Leiterplatte sowie ohne Deckel des Elektronik-und Basismoduls;
- Figur 3 -: perspektivische Seitenansicht eines Elektronikmoduls ohne Deckel für das Elektronikgerät aus Figuren 1 und 2;
- Figur 4 -: Frontansicht auf die Stirnseitenwand des Elektronikgeräts aus Figur 1 mit dem elastisch federnden Rastarm am Elektronikmodul und der zugehörigen Rastlasche mit Rastöffnung am Basismodul;
- Figur 5 -: Seiten-Schnittansicht im Schnitt B-B des Elektronikgeräts aus Figuren 1 und 4;
- Figur 6 -: Ausschnittsansicht des Elektronikgeräts aus Figur 5 im Ausschnitt C.

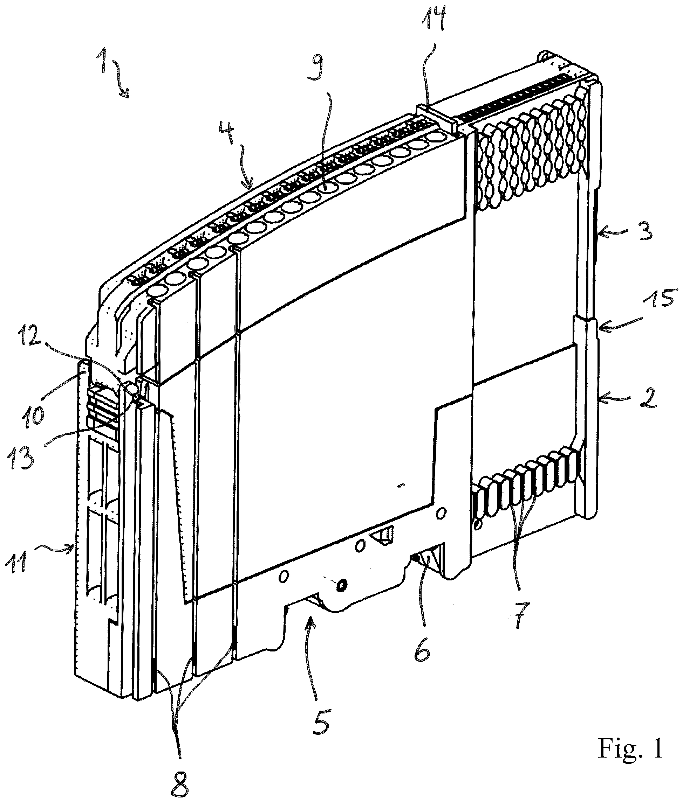

Figur 1 lässt eine perspektivische Ansicht eines Elektronikgerätes 1 erkennen, das dreiteilig aufgebaut ist und ein Basismodul 2, ein auf das Basismodul 2 aufsteckbares Elektronikmodul 3 und ein auf das Elektronikmodul 3 aufsteckbares Leiteranschlussmodul 4 hat. Das Basismodul 2 hat an seiner Unterseite einen Rastfuß 5, der mit beweglichen Tragschienen-Rastnasen 6 versehen ist, um das Basismodul 2 auf eine Tragschiene (nicht dargestellt) aufzusetzen und dort festzuklemmen.

An den einander gegenüberliegenden Seitenwänden des Basismoduls 2 sind Steckkontakte 7 vorhanden. Diese Steckkontakte 7 sind ausgebildet, um mit benachbarten Steckkontakten eines angrenzenden Elektronikgerätes 1 in Kontakt zu treten, wenn die Elektronikgeräte 1 nebeneinander in einer Reihe auf einer Tragschiene aufgerastet sind. Auf diese Weise kann mit Hilfe der Steckkontakte 7 ein durch die Reihe von Elektronikgeräten 1 hindurchgehender Datenbus etabliert werden. Zudem kann mit Steckkontakten 7 eine Versorgung der Elektronikmodule 3 mit elektrischer Energie über Spannungsversorgungsleitungen bereitgestellt werden.

Im Abstand von dieser Gruppe von Steckkontakten 7 ist eine weitere Gruppe von Steckkontakten 8 unterhalb des Leiteranschlussmoduls 4 vorgesehen. Diese sind ausgebildet, um durch eine höhere Stromtragfähigkeit eine Leistungsenergieversorgung für ein an das Elektronikgerät 1 angeschlossenen Feldbusteilnehmer bereitzustellen. Diese Feldbusteilnehmer können über elektrische Leitungen an das Elektronikgerät 1 angeschlossen werden, wenn die elektrischen Leitungen durch Leitereinführungsöffnungen 9 im Leiteranschlussmodul 4 mit zugeordneten Leiteranschlussklemmen (nicht sichtbar) kontaktiert werden, die in dem Leiteranschlussmodul 4 vorhanden sind.

Das Leiteranschlussmodul 4 ist schwenkbar mit einem Schwenklager 10 an der ersten Stirnseite 11 des Basismoduls 2 angelenkt. Hierzu tauchen vorstehende Lagerzapfen 12 am freien Ende des Leiteranschlussmoduls 4 in Rastvertiefungen 13 des Schwenklagers ein. Auf der dem Schwenklager 10 gegenüberliegenden Seite ist eine Rastlasche 14 vorhanden, mit der das Leiteranschlussmodul 4 um das Schwenklager 10 herum nach oben von dem Elektronikmodul 3 weggeklappt werden kann. Anschließend kann die Schwenklagerung aufgehoben und das Leiteranschlussmodul 4 vollständig abgenommen werden.

Im Bereich der Rastlasche 14 ist eine Verrastung vorgesehen, um das Leiteranschlussmodul 4 in dem dargestellten Betriebszustand fest an dem Elektronikmodul 3 zu verrasten oder zu verriegeln.

In dem dargestellten Betriebszustand treten die im Leiteranschlussmodul 4 aufgenommenen Leiteranschlusskontakte in Kontakt mit der Elektronik auf dem Elektronikmodul 3 und/oder in elektrische Verbindung mit den Steckkontakten 7, so dass angeschlossene Feldbusteilnehmer durch das Elektronikmodul 3 auf vorgegebene bestimmungsgemäße Weise angesteuert bzw. Signale von einem Feldbusteilnehmer empfangen und über einen Datenbus weitergeleitet werden können.

Z. B. im Fehlerfall ist es erforderlich, das Elektronikmodul 3 möglichst zügig und werkzeuglos auszutauschen. Dies darf allerdings nur dann geschehen, wenn der ordnungsgemäße Betrieb der gesteuerten Anlage nicht gefährdet wird. Zudem muss verhindert werden, dass das Elektronikmodul 3 z. B. durch Zug auf an das Leiteranschlussmodul 4 angeschlossene elektrische Leiter von dem Basismodul 2 abgezogen wird.

Hierzu ist das Elektronikmodul 3 im Bereich der ersten Stirnseite 11 dadurch an dem Basismodul 2 gesichert, dass es indirekt über das in das Schwenklager 10 aufgenommenen Leiteranschlussmoduls 4 zwangsläufig in der Betriebsposition gehalten wird. Das Elektronikmodul 3 ist somit indirekt auf der ersten Stirnseite 11 an dem Basismodul 2 festgelegt.

Auf der zweiten Stirnseite 15 des Elektronikgerätes 1, die der ersten Stirnseite 11 gegenüberliegt, ist das Elektronikmodul 3 hingegen direkt mit dem Basismodul 2 in der dargestellten Betriebsposition verrastet, wenn das Elektronikmodul 3 auf das Basismodul 2 aufgesteckt ist.

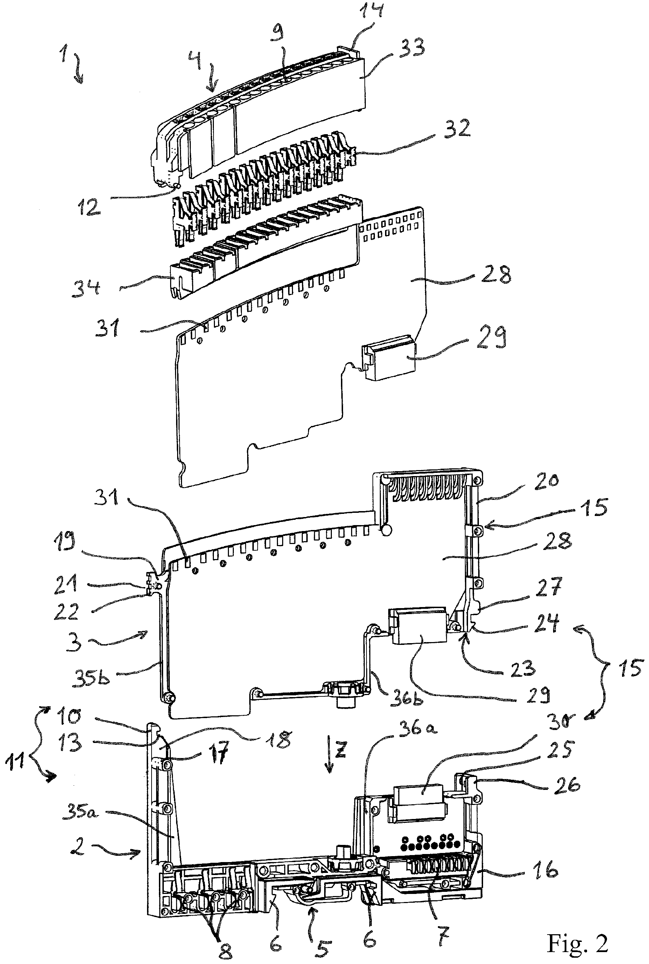

Figur 2 lässt eine perspektivische Explosionsansicht des Elektronikgerätes 1 aus Figur 1 im teilweise geöffneten Zustand erkennen. Deutlich wird, dass das Basismodul 2 ein Isolierstoffgehäuse 16 aus einem Kunststoffmaterial hat. An der ersten Stirnseite 11 ist gegenüberliegend zum Basisabschnitt mit den Steckkontakten 7, 8 ein Schwenklager 10 vorhanden, das durch Lagermulden 13 gebildet ist. Durch quer verlaufende Verbindungshülsen 17 ist eine darüberliegende Öffnung 18 im Isolierstoffgehäuse 16 gebildet, in die eine vorstehende Griffnase 19 am Isolierstoffgehäuse 20 des Elektronikmoduls 3 eintauchen kann. Diese Griffnase 19 ragt dabei in die Öffnung 18 hinein und steht vorzugsweise aus der durch die Stirnseitenwand an der ersten Stirnseite 11 definierten Ebene an der Außenseite aus der Ebene hervor.

Deutlich wird, dass an der hervorstehenden Griffnase 19 Riffelungen 21 in Form von quer zur Einsteckrichtung Z sich erstreckenden Querstegen 22 gebildet sind, die im Abstand voneinander angeordnet sind.

Mit Hilfe dieser Riffelungen 21 kann beim Übergreifen des Elektronikmoduls 3 ein Druck auf die Griffnase 19 ausgeübt und das Elektronikmodul 3 ohne Abrutschen von der Griffnase 19 mit dem Finger nach oben gezogen werden. Auf der gegenüberliegenden zweiten Stirnseite 15 ist an dem Isolierstoffgehäuse 20 des Elektronikmoduls 3 ein elastisch federnder Rastarm 23 angeordnet, der sich in Einsteckrichtung Z nach unten in Richtung Basismodul 2 erstreckt. An dem freien Ende des Rastarms 23 ist eine im Querschnitt dreieckförmige, konisch zulaufende Rastnase 24 angeordnet, die im Betriebszustand, wenn das Elektronikmodul 3 auf das Basismodul 2 aufgesteckt ist, in eine Rastöffnung 25 an einer am Isolierstoffgehäuse 16 des Basismoduls 2 angeformten Rastlasche 26 eintaucht. Damit verrastet das Elektronikmodul 3 im Betriebszustand mit der Rastnase 24 in der Rastöffnung 25 und ist an dem Basismodul 2 festgelegt.

An dem elastisch federnden Rastarm 23 ist weiterhin eine vorstehende Betätigungsnase 27 angeordnet, die sich von dem Elektronikmodul 3 zur Stirnseitenwand 15 nach außen erstreckt. Bei Übergreifen des Elektronikmoduls 3 mit der Hand kann durch Druck auf die Betätigungsnase 27 in Richtung Innenraum des Elektronikmoduls 3 mit dem Finger der Hand eines Benutzers die Rastlasche 23 in Richtung Zentrum des Elektronikmoduls 3 verlagert werden. Hierdurch gelangt die Rastnase 24 aus dem Eingriff der Rastöffnung 25 der Rastlasche 26 des Basismoduls 2, so dass das Elektronikmodul 3 entgegen der Einsteckrichtung Z lotrecht zur Tragschienenebene, d.h. entsprechend zur Ebene der Unterseite des Basismoduls 2 nach oben abgezogen werden kann.

Erkennbar ist weiterhin, dass das Elektronikmodul 3 im Innenraum seines Isolierstoffgehäuses 20 eine Leiterplatte 28 hat, die elektronische Bauelemente trägt. Die Leiterplatte 28 hat weiterhin einen Steckverbinder 29, der in Einsteckrichtung Z zum Basismodul 2 hin zeigt. Das Basismodul 2 hat einen korrespondierenden Steckverbinder 30. Beim Aufstecken des Elektronikmoduls 3 auf das Basismodul 2 gelangen die Steckverbinder 29, 30 in Eingriff zueinander, so dass ein elektrisch leitender Kontakt zwischen den elektronischen Bauelementen auf der Leiterplatte 28 und zugeordneten Steckverbindern 7 hergestellt wird.

Auf der gegenüberliegenden Seite steht die Leiterplatte 28 nach unten hervor, um mit Kontaktflächen auf der Leiterplatte 28 direkt in leitendem Kontakt mit den Steckverbindern 8 für die Leistungsenergieversorgung zu treten.

An der Oberkante der Leiterplatte 28 sind Kontaktflächen 31 vorhanden, die vorgesehen sind, um mit Leiteranschlussklemmen 32 im Leiteranschlussmodul 4 in Kontakt zu treten. Auf diese Weise kann ein an eine Leiteranschlussklemme 32 angeschlossener elektrischer Leiter mit der Elektronik auf der Leiterplatte 28 elektrisch leitend verbunden werden.

Deutlich wird, dass das Leiteranschlussmodul 4 aus einem mittels Oberteil 33 und Unterteil 34 zweiteilig aufgebauten Isolierstoffgehäuse und den darin aufgenommenen mehreren Leiteranschlusskontakten 32 gebildet wird.

Zur Führung des Elektronikmoduls 3 auf das Basismodul 2 lotrecht zu der von der Unterseite des Basismoduls 2 und einer darin eingesetzten Tragschiene aufgespannten Ebene in Einsteckrichtung Z sind in dem Isolierstoffgehäuse 16 des Basismoduls 2 und dem Isolierstoffgehäuse 20 des Elektronikmoduls 3 miteinander korrespondierende Linearführungen 35a, 35b; 36a, 36b vorhanden. Diese erstrecken sich senkrecht nach oben, d. h. lotrecht zu der von der Unterseite des Basismoduls 2 aufgespannten Ebene. Damit wird sichergestellt, dass das Elektronikmodul 3 beim Herausziehen durch Greifen der Betätigungsnase 27 und der Griffnase 19 ohne Verkanten nach oben abgezogen und beim Einstecken senkrecht nach unten auf das Basismodul 2 aufgesetzt wird.

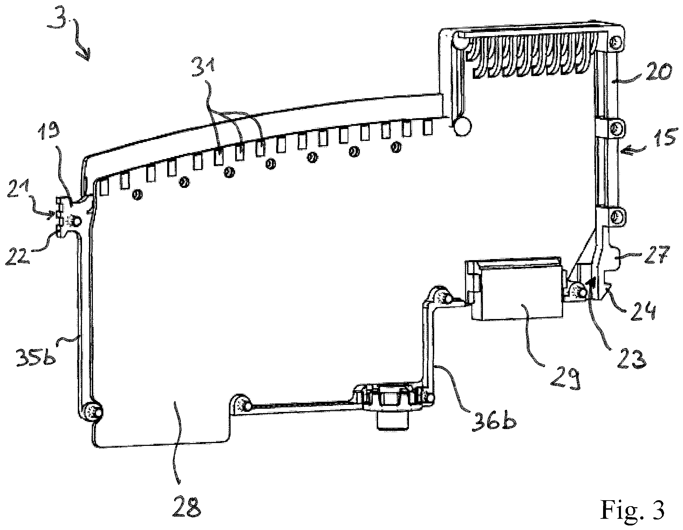

Figur 3 lässt eine Seitenansicht des geöffneten Elektronikmoduls 3 aus Figur 2 erkennen. Hierbei wird deutlich, dass die Griffnase 19 relativ zu der Linearführung 35b aus der Stirnseite des Elektronikmoduls 3 hervorsteht.

Die Kontaktflächen 31 auf der Leiterplatte 28 können entweder separate Kontaktflächen 31, separate Kontaktelemente (z.B. Lötstifte) oder Endabschnitte einer Leiterbahn auf der Leiterplatte 28 sein.

Deutlich wird auch, dass das Elektronikmodul 3 einen Versatz aufweist und in den Bereich unterhalb der Kontaktflächen 31 tiefer gezogen ist, als im Bereich des Steckverbinders 29. Dieser tiefer gezogene Abschnitt wird stirnseitig durch die Linearführung 35b und 36b begrenzt und taucht in eine entsprechende Aufnahmeöffnung mit korrespondierenden Linearführungen 35a und 36a im Basismodul 2 ein.

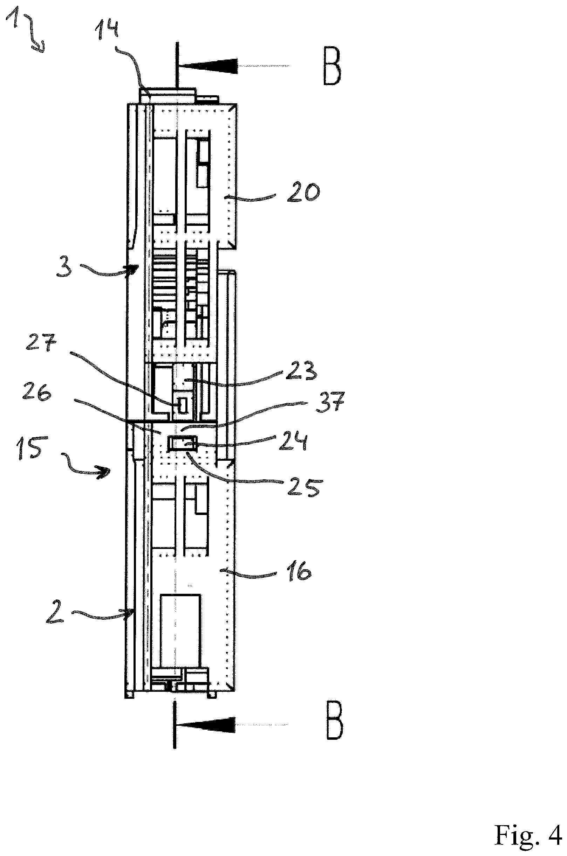

Figur 4 lässt eine Frontseitenansicht auf die zweite Stirnseite 15 des Elektronikmoduls 3 erkennen. Deutlich wird, dass in dem dargestellten Betriebszustand das Elektronikmodul 3 auf das darunter liegende Basismodul 2 aufgesteckt und mit diesem verrastet ist. Hierzu taucht die Rastnase 24 des elastisch federnden Rastarms 23 in die Rastöffnung 25 der Rastlasche 26 ein. Diese Rastlasche 26 ist integral aus dem Kunststoffmaterial des Isolierstoffgehäuses 16 des Basismoduls 2 gebildet. Die Rastöffnung 14 ist durch einen Quersteg 37 am freien Ende der Rastlasche 26 begrenzt. Dieser Quersteg 37 bildet einen Anschlag für die Rastnase 24 des elastisch federnden Rastarms 23. Dieser elastisch federnde Rastarm 23 ist seinerseits integral aus dem Kunststoffmaterial des Isolierstoffgehäuses 20 des Elektronikmoduls 3 geformt.

Deutlich wird weiterhin, dass oberhalb des Querstegs 37 der Rastlasche 26 im dargestellten Betriebszustand die Betätigungsnase 27 des Rastarms 23 hervorsteht. Diese ragt soweit aus der Ebene der Stirnseitenwand an der zweiten Stirnseite 15 heraus oder ist in der zweiten Stirnseite 15 über eine Öffnung zugänglich, dass beim Übergreifen des Elektronikmoduls 3 mit der Hand Druck durch einen Finger der Hand eines Benutzers auf die vorstehende Betätigungsnase 27 ausgeübt werden kann. Dann wird durch Druck in Richtung Zentrum des Elektronikmoduls 3 der Rastarm verschwenkt und die Verriegelung aufgehoben und das Elektronikmodul 3 kann nach oben abgezogen werden. Dies wird durch die Betätigungsnase 27 und die gegenüberliegende Griffnase 19 erleichtert, mit dem das Elektronikmodul 3 an einer Hand mit zwei Fingern gegriffen und abgezogen werden kann.

Figur 4 zeigt weiterhin die Schnittebene B-B durch das Elektronikgerät 1.

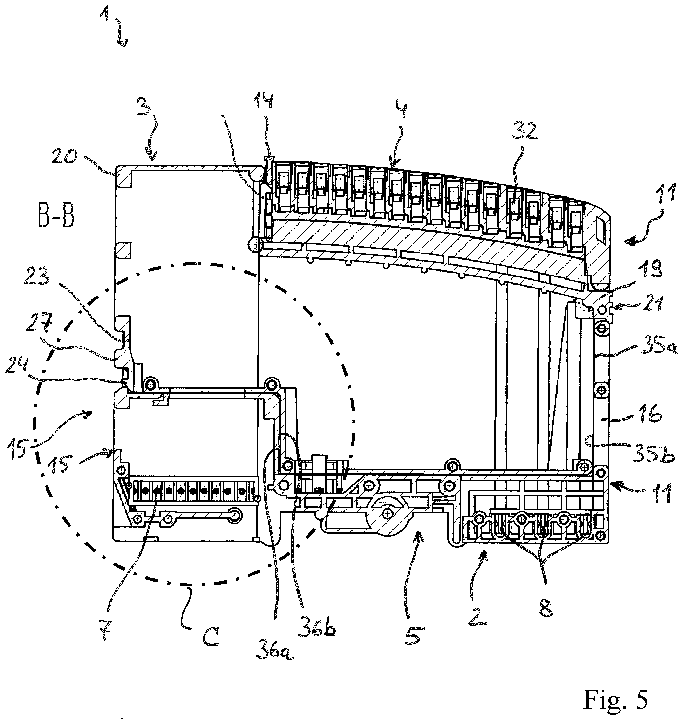

Figur 5 lässt eine Seiten-Schnittansicht im Schnitt B-B gemäß Figur 4 durch das Elektronikgerät 1 erkennen. Hierbei wird deutlich, dass sich die Betätigungsnase 24 und die Griffnase 19 gegenüberliegen. Dabei wird deutlich, dass die Betätigungsnase 27 wesentlich näher an der Unterseite des Basismoduls 2 angeordnet ist, als die Griffnase 19. Die Griffnase 19 befindet sich somit näher an der Oberseite des Elektronikgerätes 1, als die Betätigungsnase 27. Dies hat den Vorteil, dass der umlaufende Abstand zwischen Betätigungsnase 27 und Griffnase 19 so weit reduziert ist, dass z. B. ein Druck auf die Betätigungsnase 27 mit dem Daumen und auf die Griffnase 19 mit dem Mittelfinger bei normaler Handgröße eines Benutzers möglich ist und das Elektronikgerät 1 bequem mit einer Hand übergriffen werden kann. Zudem kann die Länge des Rastarms 23 hierdurch relativ kurz gehalten werden, wodurch Einbauraum gespart wird und die Rast- und Auslenkeigenschaften des elastisch federnden Rastarms 23 verbessert werden. Trotz des Höhenversatzes zwischen Betätigungsnase 27 und Griffnase 19 wird ein verkantetes Herausziehen des Elektronikmoduls 3 aus dem Basismodul 2 bzw. ein verkantetes Einsetzen von Elektronikmodul 3 in das Basismodul 2 durch die Linearführungen 35a, 35b; 36a, 36b verhindert.

Deutlich wird auch, dass zumindest die vorstehende Griffnase 19 etwas mit ihrer Riffelung 21 aus der Außenfläche der ersten Stirnseite 11 hervorsteht.

Die gegenüberliegende Betätigungsnase 27 hingegen endet in der Ebene der zweiten Stirnseite 15. Sie kann dennoch gut mit dem Finger betätigt und gehalten werden, da im Isolierstoffgehäuse 20 des Elektronikmoduls 3 um die vorstehende Betätigungsnase 27 herum eine hinreichend große Öffnung vorhanden ist.

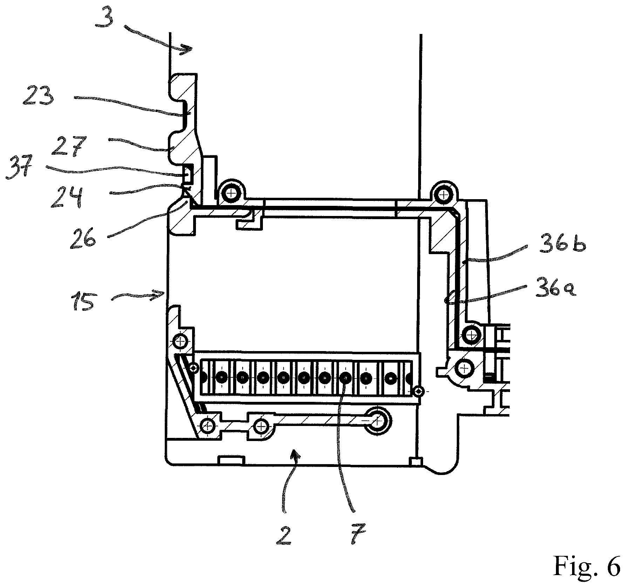

Figur 6 lässt eine Ausschnittsansicht des Elektronikgerätes 1 in dem in Figur 5 skizzierten Ausschnitt C im Schnitt B-B erkennen. Dabei wird nochmals deutlich, dass der elastisch federnde Rastarm 23 mit seinem freien Ende in Richtung Basismodul 2 ausgerichtet ist, wenn das Elektronikmodul 3 bestimmungsgemäß im dargestellten Betriebszustand auf das Basismodul 2 aufgesetzt ist. Deutlich wird auch, dass die keilförmig zulaufende Rastnase mit ihrer Erhebung aus dem Zentrum des Elektronikmoduls 3 herausragt, um dort mit dem Quersteg 37 der Rastlasche 26 des Basismoduls 2 einen zusammenwirkenden Anschlag zu bilden.

## Patentansprüche

1. Elektronikgerät (1) mit einem Basismodul (2) und mit einem auf das Basismodul (2) lösbar aufsteckbaren Elektronikmodul (3), wobei das Basismodul (2) ein Isolierstoffgehäuse (16) mit einem Rastfuß (5) zum Aufrasten des Basismoduls (2) auf eine Tragschiene und Steckkontakte (7, 8) an den Seitenwänden aufweist, und wobei das Elektronikmodul (3) ein Isolierstoffgehäuse (20) aufweist und im aufgesteckten Zustand auf das Basismodul (2) mit zugeordneten Steckkontakten (7, 8) des Basismoduls (2) verbindbar ist, und wobei das Basismodul (2) und das Elektronikmodul (3) zusammenwirkende Rastelemente zur Verrastung von Basismodul (2) und Elektronikmodul (3) miteinander haben, wenn das Elektronikmodul (3) auf das Basismodul (2) aufgesteckt ist, **dadurch gekennzeichnet, dass** ein Rastelement des Elektronikmoduls (3) an einer zweiten Stirnseite (15) des Elektronikgerätes (1) eine Betätigungsnase (27) hat und dass das Elektronikmodul (3) an seiner der zweiten Stirnseite (15) des Elektronikgerätes (1) gegenüberliegenden ersten Stirnseite (11) des Elektronikgerätes (1) eine Griffnase (19) hat, und dass das Elektronikmodul (3) und das Basismodul (2) miteinander zusammenwirkende Linearführungen (35a, 35b, 36a, 36b) haben, wobei das Elektronikmodul (3) mit den Linearführungen (35a, 35b, 36a, 36b) an dem Basismodul (2) linear verschiebbar gehalten und an dem Basismodul (2) aufnehmbar ist.

2. Elektronikgerät (1) nach Anspruch 1, **dadurch gekennzeichnet, dass** ein elastisch federnder Rastarm (23) integral mit dem Isolierstoffgehäuse (20) des Elektronikmoduls (3) geformt ist, dass der Rastarm (23) die Betätigungsnase (27) hat und an seinem freien Ende eine Rastnase (24) trägt und mit seinem freien Ende im an dem Basismodul (2) verrasteten Aufsteckzustand zu dem Basismodul (2) hin gerichtet ist, und dass an dem Isolierstoffgehäuse (16) des Basismoduls (2) eine in Richtung Elektronikmodul (3) hervorstehende Rastlasche (26) mit der durch einen Quersteg (37) am freien Ende der Rastlasche (26) begrenzten Rastöffnung (25) vorgesehen ist.

3. Elektronikgerät (1) nach Anspruch 1 oder 2, **dadurch gekennzeichnet, dass** an einer der Stirnseiten (15) des Elektronikgerätes (1) Rastelemente mit dem elastisch federnden Rastarm (23) und der zugeordneten Rastöffnung (25) und an der gegenüberliegenden Stirnseite (11) eine indirekte Verriegelung des Elektronikmoduls (3) an dem Basismodul (2) vorgesehen ist.

4. Elektronikgerät (1) nach Anspruch 3, **dadurch gekennzeichnet, dass** das Elektronikgerät (1) ein auf das Elektronikmodul (3) aufsteckbares Leiteranschlussmodul (4) mit Leiteranschlussklemmen (32) zum Anschließen von elektrischen Leitungen hat, wobei die Leiteranschlussklemmen (32) im Betriebszustand, in dem das Leiteranschlussmodul (4) auf das Elektronikmodul (3) aufgesteckt ist, elektrisch leitend mit dem Elektronikmodul (3) verbunden sind, und wobei das Leiteranschlussmodul (4) und das Basismodul (2) auf der Stirnseite (11), die dem elastisch federnden Rastarm (23) und der zugeordneten Rastöffnung (25) gegenüberliegt, Verriegelungselemente (12, 13) zum Festlegen des Leiteranschlussmoduls (4) an dem Basismodul (2) haben.

5. Elektronikgerät (1) nach einem der vorhergehenden Ansprüche, **dadurch gekennzeichnet, dass** die Griffnase (19) in eine Öffnung (18) im Isolierstoffgehäuse (16) des Basismoduls (2) hineinragt und bevorzugt aus der Stirnseite (11) des Basismoduls (2) herausragt.

6. Elektronikgerät (1) nach Anspruch 5, **dadurch gekennzeichnet, dass** die Öffnung (18) in die vom Basismodul (2) entgegengesetzte Richtung offen ist.

7. Elektronikgerät (1) nach einem der vorhergehenden Ansprüche, **dadurch gekennzeichnet, dass** die Griffnase (19) benachbart zu einem im Betriebszustand auf das Elektronikmodul (3) aufgesteckten Leiteranschlussmodul (4) angeordnet ist.

8. Elektronikgerät (1) nach einem der vorhergehenden Ansprüche, **dadurch gekennzeichnet, dass** der federnde Rastarm (23) mit der Betätigungsnase (27) näher an der durch die Unterseite des Basismoduls (2) mit dem Rastfuß (5) aufgespannten Ebene liegt, als die vorstehende Griffnase (19), die der Betätigungsnase (27) gegenüberliegt.

9. Elektronikgerät (1) nach einem der vorhergehenden Ansprüche, **dadurch gekennzeichnet, dass** die Betätigungsnase (27) am elastisch federnden Rastarm (23) und/oder die Griffnase (19) eine Riffelung (21), insbesondere quer zur Einsteckrichtung verlaufende und voneinander beabstandete Querstege (22) hat.

## Claims

1. An electronic device (1) having a base module (2) and an electronic module (3) that can be plugged onto the base module (2) in a detachable manner, wherein the base module (2) comprises an insulating-material housing (16) having a latching base (5) for latching the base module (2) onto a carrier rail and plug contacts (7, 8) on the side walls, and wherein the electronic module (3) comprises an insulating-material housing (20) and when plugged onto the base module (2) can be connected to allocated plug contacts (7, 8) of the base module (2), and wherein the base module (2) and the electronic module (3) have interacting latching elements for latching the base module (2) and the electronic module (3) to one another when the electronic module (3) is plugged onto the base module (2), **characterized in that** a latching element of the electronic module (3) has an actuating lug (27) on a second end face (15) of the electronic device (1) and that the electronic module (3) has a catch lug (19) on its first end face (11) of the electronic device (1) that lies opposite the second end face (15) of the electronic device (1), and that the electronic module (3) and the base module (2) have mutually interacting linear guides (35a, 35b, 36a, 36b), wherein the electronic module (3) can be held on the base module (2) by the linear guides (35a, 35b, 36a, 36b) in a linear displaceable manner.

2. The electronic device (1) as claimed in claim 1, **characterized in that** an elastically resilient latching arm (23) is formed as one in an integral manner with the insulating-material housing (20) of the electronic module (3), that the latching arm (23) has the actuating lug (27) and at its free end supports a latching lug (24) and, in the plugged-on state latched onto the base module (2), faces with its free end towards the base module (2), and that a latching protrusion (26) that protrudes in the direction towards the electronic module (3) is provided on the insulating-material housing (16) of the base module (2), said latching protrusion having a latching opening (25) that is delimited by means of a connecting piece (37) on the free end of the latching protrusion (26).

3. The electronic device (1) as claimed in claim 1 or 2, **characterized in that** at one of the end faces (15) of the electronic device (1) latching elements having the elastically resilient latching arm (23) and the allocated latching opening (25) are provided and at the opposite lying end face (11) the electronic module (3) is indirectly locked on the base module (2).

4. The electronic device (1) as claimed in claim 3, **characterized in that** the electronic device (1) has a conductor connecting module (4) that can be plugged onto the electronic module (3) and comprises conductor connecting terminals (32) for connecting electrical lines, wherein the conductor connecting terminals (32) are connected to the electronic module (3) in an electrically conductive manner, in the operating state in which the conductor connector module (4) is plugged onto the electronic module (3), and wherein the conductor connecting module (4) and the base module (2) have on the end face (11) locking elements (12, 13) for fixing the conductor connecting module (4) to the base module (2), said end face lying opposite the elastically resilient latching arm (23) and the allocated latching opening (25) .

5. The electronic device (1) as claimed in any one of the preceding claims, **characterized in that** the catch lug (19) protrudes into an opening (18) in the insulated material housing (16) of the base module (2) and preferably protrudes out of the end face (11) of the base module (2).

6. The electronic device (1) as claimed in claim 5, **characterized in that** the opening (18) is open in the direction that faces away from the base module (2) .

7. The electronic device (1) as claimed in any one of the preceding claims, **characterized in that** the catch lug (19) is arranged adjacent to a conductor connecting module (4) that in the operating state is plugged onto the electronic module (3).

8. The electronic device (1) as claimed in any one of the preceding claims, **characterized in that** the resilient latching arm (23) lies closer to the actuating lug (27) on the plane that extends through the lower face of the base module (2) having the latching base (5) than the protruding catch lug (19) that lies opposite the actuating lug (27).

9. The electronic device (1) as claimed in any one of the preceding claims, **characterized in that** the actuating lug (27) has flutings (21), in particular connecting pieces (22) that extend in a transverse manner with respect to the plugging-in direction and are spaced apart from one another, on the elastically resilient latching arm (23) and/or the catch lug (19).

## Revendications

1. Appareil électronique (1) comportant un module de base (2) et un module électronique (3) qui peut être enfiché de manière amovible sur le module de base (2), dans lequel le module de base (2) comporte un boîtier en matériau isolant (16) muni d'un pied d'encliquetage (5) qui sert à encliqueter le module de base (2) sur un rail de support et de contacts enfichables (7, 8) sur les parois latérales, et dans lequel le module électronique (3) comporte un boîtier en matériau isolant (20) et, à l'état enfiché, peut être relié à des contacts enfichables associés (7, 8) du module de base (2), et dans lequel le module de base (2) et le module électronique (3) présentent des éléments d'encliquetage coopérant pour encliqueter le module de base (2) et le module électronique (3) l'un avec l'autre lorsque le module électronique (3) est enfiché sur le module de base (2), **caractérisé en ce qu'**un élément d'encliquetage du module électronique (3) présente un ergot d'actionnement (27) sur une seconde face frontale (15) de l'appareil électronique (1) et **en ce que** le module électronique (3) présente un ergot de préhension (19) sur sa première face frontale (11) de l'appareil électronique (1) qui est opposée à la seconde face frontale (15) de l'appareil électronique (1), et **en ce que** le module électronique (3) et le module de base (2) présentent des guides linéaires (35a, 35b, 36a, 36b) coopérant les uns avec les autres, dans lequel le module électronique (3) est maintenu par les guides linéaires (35a, 35b, 36a, 36b) de manière à se déplacer linéairement sur le module de base (2) et à pouvoir être reçu sur le module de base (2).

2. Appareil électronique (1) selon la revendication 1, **caractérisé en ce qu'**un bras d'encliquetage déformable élastiquement (23) est formé solidaire du boîtier en matériau isolant (20) du module électronique (3), **en ce que** le bras d'encliquetage (23) présente l'ergot d'actionnement (27) et porte un ergot d'encliquetage (24) à son extrémité libre et, à l'état encliqueté par son extrémité libre dans le module de base (2), est dirigé vers le module de base (2), et **en ce qu'**il est prévu, sur le boîtier en matériau isolant (16) du module de base (2), une patte d'encliquetage (26) dépassant dans la direction du module électronique (3) et comportant l'ouverture d'encliquetage (25) délimitée par une barrette transversale (37) à l'extrémité libre de la patte d'encliquetage (26).

3. Appareil électronique (1) selon la revendication 1 ou 2, **caractérisé en ce qu'**il est prévu sur l'une des faces frontales (15) de l'appareil électronique (1) des éléments d'encliquetage comportant le bras d'encliquetage déformable élastiquement (23) et l'ouverture d'encliquetage (25) associée et **en ce qu'**il est prévu sur la face frontale opposée (11) un verrouillage indirect du module électronique (3) sur le module de base (2) .

4. Appareil électronique (1) selon la revendication 3, **caractérisé en ce que** l'appareil électronique (1) présente un module de connexion de conducteurs (4) qui peut être enfiché sur le module électronique (3) par des bornes de connexion de conducteurs (32) pour la connexion de lignes électriques, dans lequel les bornes de connexion de conducteurs (32) sont reliées électriquement au module électronique (3) dans un état de fonctionnement dans lequel le module de connexion de conducteurs (4) est enfiché sur le module électronique (3), et dans lequel le module de connexion de conducteurs (4) et le module de base (2) présentent, sur la face frontale (11) qui est opposée au bras d'encliquetage déformable élastiquement (23) et à l'ouverture d'encliquetage associée (25), des éléments d'encliquetage (12, 13) destinés à fixer le module de connexion de conducteurs (4) sur le module de base (2).

5. Appareil électronique (1) selon l'une des revendications précédentes, **caractérisé en ce que** l'ergot de préhension (19) pénètre dans une ouverture (18) ménagée dans le boîtier en matériau isolant (16) du module de base (2) et dépasse de préférence de la face frontale (11) du module de base (2).

6. Appareil électronique (1) selon la revendication 5, **caractérisé en ce que** l'ouverture (18) s'ouvre dans la direction opposée au module de base (2).

7. Appareil électronique (1) selon l'une des revendications précédentes, **caractérisé en ce que** l'ergot de préhension (19) est disposé de manière adjacente à un module de connexion de conducteurs (4) enfiché sur le module électronique (3) à l'état de fonctionnement.

8. Appareil électronique (1) selon l'une des revendications précédentes, **caractérisé en ce que** le bras d'encliquetage déformable élastiquement (23) muni de l'ergot d'actionnement (27) est plus proche du plan formé par la face inférieure du module de base (2) avec le pied d'encliquetage (5) que l'ergot de préhension (19) faisant saillie qui est opposé à l'ergot d'actionnement (27).

9. Dispositif électronique (1) selon l'une des revendications précédentes, **caractérisé en ce que** l'ergot d'actionnement (27) présente sur le bras d'encliquetage déformable élastiquement (23) et/ou l'ergot de préhension (19) une nervure (21), en particulier des barrettes transversales (22) s'étendant transversalement à la direction d'enfichage et espacées les unes des autres.
